# FASCICULE DE BREVET EUROPEEN

(11) **EP 0 895 352 B1**
(45) Date de publication et mention de la délivrance du brevet: **07.04.2010**
(21) Numéro de dépôt: 98401795.4
(22) Date de dépôt: 16.07.1998
(51) Int. Cl.: H03G 3/30

(54) **Procédé et dispositif de contrôle de l'enveloppe d'un signal radio**
Verfahren und Vorrichtung zur Regelung der Hüllkurve eines Radiosignals
Method and device of controlling the envelope of a radiosignal

(30) Priorité: 31.07.1997 FR 9709787
(43) Date de publication de la demande: 03.02.1999
(73) Titulaire: IPG Electronics 504 Limited, St Peter Port Guernsey GY1 3QL (GB)
(72) Inventeur: Greverie, Franck, 75002 Paris (FR)
(74) Mandataire: Talbot-Ponsonby, Clare Josephine

(56) Documents cités:
- EP-A- 0 546 693
- US-A- 5 412 341
- US-A- 5 426 641
- US-A- 5 621 763

## Description

La présente invention concerne un procédé de contrôle de l'enveloppe d'un signal radio à transmettre à partir d'une station de radiocommunications mobiles, et un dispositif pour la mise en oeuvre du procédé.

Le domaine plus particulièrement visé par l'invention est celui des stations de radiocommunications mobiles utilisant un système cellulaire numérique à accès multiple à répartition temporelle, du type GSM (initiales anglo-saxonnes mises pour Global System for Mobile communication), DCS (initiales anglo-saxonnes mises pour Digital Cellular System), ou encore PCS (initiales anglo-saxonnes mises pour Personal Communication System).

Dans ce type de système, les différents stations, en l'occurrence d'une part, les stations mobiles telles que les terminaux montés sur véhicules, les portables et les portatifs, et d'autre part, les stations de base, échangent des données qui sont transmises sous forme de paquets ("bursts" dans la terminologie anglo-saxonne). Chaque paquet est émis par une station dans un intervalle de temps prédéterminé d'une structure de trame donnée. Chaque paquet possède en outre une forme particulière de l'enveloppe du signal radio présentant un palier correspondant à la partie utile du signal à transmettre, par exemple la parole sous forme de code, le palier étant précédé d'une rampe montante et suivi d'une rampe descendante correspondant à des temps de garde qui entourent la partie utile du signal.

La formation d'un paquet au niveau de l'émetteur d'une station s'effectue classiquement en amplifiant la puissance du signal radio à transmettre au moyen d'un amplificateur de puissance , et en contrôlant l'enveloppe du signal radio issu de l'amplificateur de puissance par application sur une entrée de commande de l'amplificateur d'une tension variable en fonction de la forme d'enveloppe souhaitée. L'amplificateur de puissance emploie classiquement un transistor à effet de champ (ou plusieurs). Cet amplificateur peut être fabriqué par exemple à base de transistors MESFET (initiales anglo-saxonnes mises pour MEtal Semiconductor Field Effect Transistor) ou HEMT (initiales anglo-saxonnes mises pour High Electron Mobility Transistor) ou P-HEMT ( HEMT pseudomorphique), sur substrat AsGa ou InAsGa.

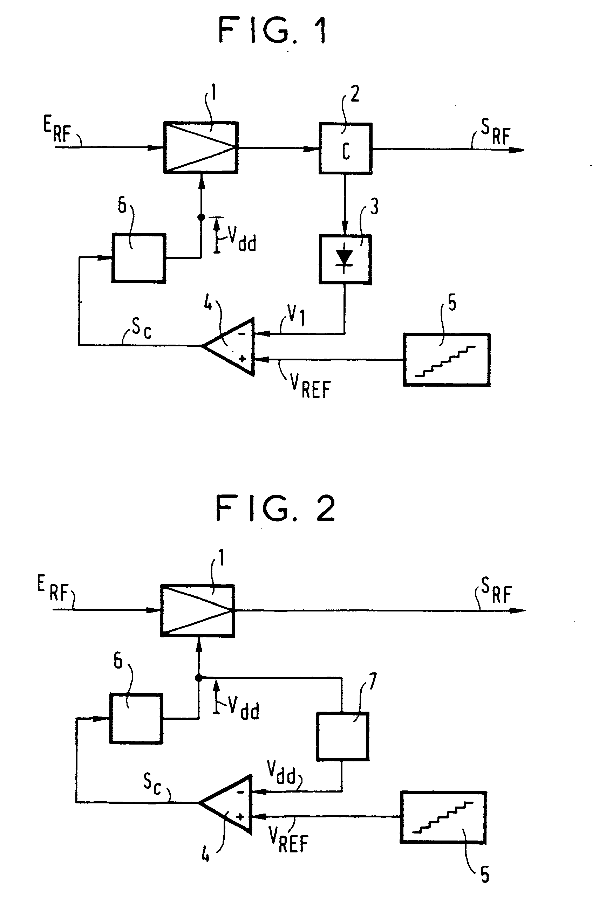

La figure 1 illustre, sous forme de synoptique simplifié, un dispositif connu de contrôle de l'enveloppe d'un signal radio en vue de la formation d'un paquet d'enveloppe donnée, selon le principe précédent :

En référence à cette figure, un signal radio E_{RF} en provenance d'un circuit d'entrée non représenté est amplifié au moyen d'un amplificateur de puissance 1, par exemple du type décrit précédemment. Une fraction de la puissance du signal en sortie de l'amplificateur de puissance 1 est prélevée au moyen d'un coupleur directionnel 2 et délivrée à une boucle d'asservissement comprenant un détecteur d'enveloppe 3. Des moyens de comparaison 4 effectuent une comparaison entre un premier signal V₁ issu du détecteur d'enveloppe 3 et un second signal de référence V_{REF} issu d'un générateur de rampes 5 et fonction de l'enveloppe souhaitée. Le signal S_{C} en sortie des moyens de comparaison 4 commande à son tour des moyens de contrôle 6, qui viennent modifier la tension de commande V_{dd} appliquée sur l'amplificateur de puissance 1 en fonction du résultat de la comparaison.

La boucle d'asservissement précédente permet ainsi de générer un "burst" S_{RF} ayant l'enveloppe souhaitée à destination d'un circuit de sortie non représenté comportant l'antenne d'émission.

Bien entendu, le générateur de rampes 5 peut être remplacé par tout générateur d'un signal de référence correspondant à l'enveloppe souhaitée et permettant de contrôler le niveau de puissance d'un signal radio issu d'un amplificateur de puissance pour qu'il corresponde à cette enveloppe.

L'inconvénient du dispositif selon la figure 1 réside dans le principe même de la détection d'enveloppe.

En effet, le coupleur directionnel 2, nécessaire pour prélever le signal radio en sortie de l'amplificateur de puissance 1 en vue de détecter son enveloppe, introduit des pertes d'insertion derrière l'amplificateur 1. Ainsi, afin que la puissance maximale du signal S_{RF} corresponde aux exigences imposées par les normes (typiquement 2 Watts pour un terminal portatif utilisant le système GSM, et 1 Watt pour un terminal portatif utilisant le système DCS ou PCS), le signal issu de l'amplificateur de puissance doit présenter une puissance supérieure à celle du signal S_{RF} pour tenir compte de ces pertes d'insertion. Il en résulte une consommation d'énergie non optimisée, dans un domaine où l'on recherche au contraire constamment à réduire au maximum la consommation, notamment au niveau des terminaux portatifs fonctionnant sur batterie.

En outre, la station de radiocommunications mobiles doit être capable d'émettre à des puissances qui sont inférieures au niveau maximum imposé par les normes. Ainsi, le détecteur d'enveloppe devrait présenter une dynamique importante pour pouvoir fonctionner correctement aussi bien aux puissances maximales qu'aux puissances minimales.

La présente invention a pour but de proposer un procédé et un dispositif de contrôle de l'enveloppe d'un signal radio qui s'affranchisse de la détection d'enveloppe de ce signal.

Pour ce faire, l'invention a pour objet un procédé de contrôle de l'enveloppe d'un signal radio à transmettre depuis une station de radiocommunications mobiles, ledit signal radio étant issu d'un amplificateur de puissance à effet de champ fabriqué à partir de transistors sur substrat à base d'AsGa, caractérisé en ce qu'il comporte les étapes suivantes :
- prélever une tension de commande appliquée sur l'amplificateur de puissance;
- comparer la tension de commande prélevée avec une tension de référence prédéfinie;
- faire varier ladite tension de commande appliquée sur l'amplificateur de puissance en fonction du résultat de la comparaison.

La présente invention a également pour objet un dispositif de contrôle de l'enveloppe d'un signal radio à transmettre depuis une station de radiocommunications mobiles, ledit signal radio étant issu d'un amplificateur de puissance à effet de champ fabriqué à partir de transistors sur substrat à base d'AsGa, caractérisé en ce qu'il comporte:
- des moyens pour prélever une tension de commande appliquée sur l'amplificateur de puissance;
- des moyens de comparaison de la tension de commande prélevée avec une tension de référence prédéfinie;
- des moyens de contrôle pour faire varier ladite tension de commande appliquée sur l'amplificateur en fonction du résultat de la comparaison.

L'invention résulte des essais conduits par la Demanderesse qui ont montré que, dans le cas particulier d'un amplificateur de puissance à effet de champ réalisé à partir de transistors sur substrat à base d'AsGa, la puissance du signal en sortie d'un tel amplificateur était une image fidèle de la tension de commande qui lui est appliquée, et qui détermine la polarisation de drain du ou des transistors AsGa amplificateurs composant l'amplificateur de puissance. Cette invention s'applique aux amplificateurs du type décrit précédemment du fait qu'ils sont très stables en température, et qu'ils délivrent donc la même puissance de sortie pour une tension de commande donnée, quelle que soit la température. Ainsi, il devient possible de contrôler le niveau de la puissance du signal en sortie de l'amplificateur sans avoir ni à prélever ce signal, ni à en détecter son enveloppe. Il suffit de prélever la tension de commande de l'amplificateur et d'asservir la valeur de cette tension en fonction du résultat de la comparaison entre cette tension et le signal de référence.

Les différents avantages procurés par l'invention apparaîtront clairement au vu de la description suivante du contrôle de l'enveloppe d'un signal radio de type "burst", faite en référence aux figures annexées, dans lesquelles :
- la figure 1, précédemment décrite, illustre sous forme de synoptique simplifié, un dispositif de contrôle de l'enveloppe d'un signal radio de type "burst", utilisant le principe de la détection d'enveloppe;
- la figure 2 illustre, sous forme de synoptique simplifié, le dispositif de contrôle de l'enveloppe d'un signal radio de type "burst" conforme à l'invention;
- la figure 3 représente un mode de réalisation préféré d'un dispositif de contrôle de l'enveloppe d'un signal radio de type "burst" selon l'invention.

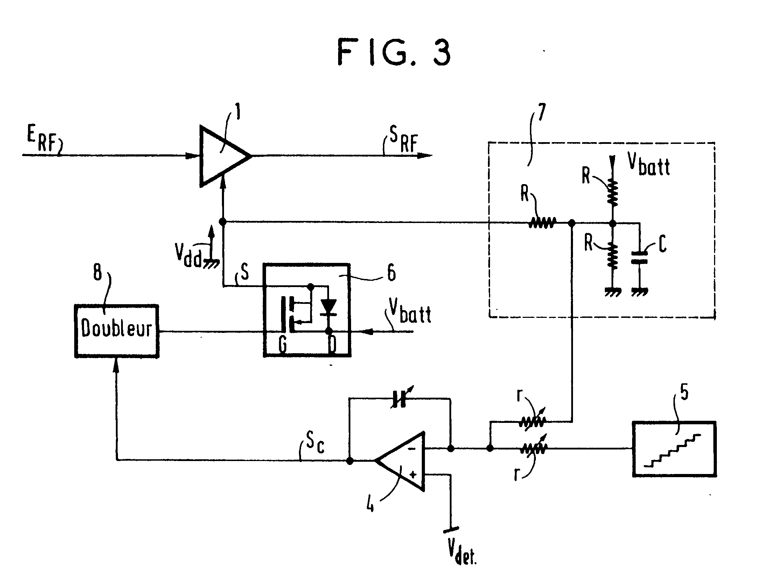

Pour faciliter la compréhension de l'invention, les figures 2 et 3 reprennent les mêmes références pour les éléments communs déjà décrits en référence à la figure 1.

Conformément à la présente invention, et en référence à la figure 2, le dispositif de contrôle de l'enveloppe du signal S_{RF} issu d'un amplificateur de puissance 1 à effet de champ fabriqué à partir de transistors sur substrat à base d'AsGa, comporte des moyens 7 pour prélever directement la valeur de la tension de commande V_{dd} appliquée sur l'amplificateur de puissance 1. Cette tension de commande prélevée est alors comparée avec la tension V_{REF} formant le signal de référence issu d'un générateur de rampes 5 par l'intermédiaire de moyens de comparaison 4. Le signal S_{C} issu des moyens de comparaison 4 vient commander des moyens de contrôle 6 qui font varier la valeur de la tension de commande de l'amplificateur 1 en fonction du résultat de la comparaison.

En comparant le synoptique de la figure 2 avec celui de la figure 1, on note que, grâce à l'invention, le signal S_{RF} à transmettre à un circuit de sortie non représenté est directement issu de l'amplificateur de puissance 1. On a donc supprimé les pertes d'insertion provoquées par la présence du coupleur 2 (figure 1). Il en résulte une consommation d'énergie optimisée.

En outre, il n'est plus nécessaire de prévoir un composant détecteur d'enveloppe présentant une dynamique importante pour fonctionner correctement sur toute la gamme de puissances possibles.

Enfin, on réduit le nombre de composants nécessaires au contrôle de l'enveloppe du signal radio, ce qui constitue incontestablement un avantage en terme de coût de fabrication, mais également, dans le cas particulier des terminaux portatifs, en termes d'encombrement, de poids et de consommation d'énergie.

La figure 3 illustre un exemple de réalisation préféré d'un dispositif fonctionnant selon le principe exposé en référence à la figure 2 :

Sur cette figure, les moyens de comparaison 4 comportent un amplificateur différentiel relié, sur une première entrée, à une tension prédéterminée V_{det}, et recevant sur une seconde entrée, via des résistances variables r, d'une part, la tension formant signal de référence issue du générateur 5, et d'autre part, le signal représentatif de la tension de commande V_{dd} prélevée par les moyens 7. Ces derniers comportent des résistances R montées en pont diviseur de tension entre une tension d'alimentation V_{batt} et la masse, ainsi qu'un condensateur C, l'ensemble permettant d'adapter le niveau de la tension de commande prélevée en fonction de la valeur de la tension prédéterminée V_{det}. Les moyens de contrôle 6 comportent de préférence un transistor MOSFET canal N dont la grille G reçoit le signal de commande S_{C} issu des moyens de comparaison 4, dont le drain D reçoit la tension d'alimentation V_{batt}, et dont la source S est reliée à l'entrée de commande de l'amplificateur de puissance 1. Bien entendu, d'autres composants agissant comme résistance variable peuvent être envisagés à la place du MOSFET canal N. Un doubleur 8 est de préférence utilisé entre les moyens de comparaison 4 et le MOSFET 6 de façon à assurer un niveau de tension de grille minimum suffisant par rapport à la tension d'alimentation.

Bien que l'invention ait été décrite en relation avec le contrôle de l'enveloppe d'un signal radio particulier, à savoir un "burst", nécessitant la génération de rampes montantes et descendantes, on comprendra que le principe selon l'invention peut être généralisé à tout signal radio à transmettre depuis une station de radiocommunications mobiles dès lors que se pose le problème du contrôle précis de l'enveloppe de ce signal.

## Revendications

1. Procédé de contrôle de l'enveloppe d'un signal radio à transmettre depuis une station de radiocommunications mobiles, ledit signal radio étant issu d'un amplificateur de puissance (1) à effet de champ fabriqué à partir de transistors sur substrat à base d'AsGa, **caractérisé en ce qu'**il comporte les étapes suivantes :
- prélever une tension de commande (V_{dd)} appliquée sur l'amplificateur de puissance (1);
- comparer la tension de commande prélevée avec une tension de référence prédéfinie (V_{REF});
- faire varier ladite tension de commande (V_{dd}) appliquée sur l'amplificateur de puissance (1) en fonction du résultat de la comparaison.

2. Dispositif de contrôle de l'enveloppe d'un signal radio à transmettre depuis une station de radiocommunications mobiles, ledit signal radio étant issu d'un amplificateur de puissance (1) à effet de champ fabriqué à partir de transistors sur substrat à base d'AsGa, **caractérisé en ce qu'**il comporte:
- des moyens (7) pour prélever une tension de commande (V_{dd}) appliquée sur l'amplificateur de puissance (1);
- des moyens de comparaison (4) de la tension de commande prélevée avec une tension de référence prédéfinie (V_{REF});
- des moyens de contrôle (6) pour faire varier ladite tension de commande appliquée sur l'amplificateur de puissance (1) en fonction du résultat de la comparaison.

3. Dispositif de contrôle selon la revendication 2, **caractérisé en ce que**, ladite station fonctionnant selon un système cellulaire numérique à accès multiple à répartition temporelle, le signal radio à transmettre possède une forme d'enveloppe présentant un palier précédé par une rampe montante et suivi d'une rampe descendante, et la tension de référence prédéfinie (V_{REF}) est issue d'un générateur (5) de rampes selon ladite forme d'enveloppe.

4. Dispositif selon l'une quelconque des revendications 2 ou 3 **caractérisé en ce que** les moyens de comparaison (4) comportent un amplificateur différentiel relié, sur une première entrée, à une tension prédéterminée (V_{det}), et recevant sur une seconde entrée, d'une part, la tension de commande prélevée, et d'autre part, la tension de référence prédéfinie.

5. Dispositif selon la revendication 4, **caractérisé en ce que** les moyens (7) pour prélever la tension de commande permettent d'adapter le niveau de la tension de commande prélevée en fonction de la valeur de la tension prédéterminée (V_{det}) reliée à l'amplificateur différentiel (4).

6. Dispositif de contrôle selon l'une quelconque des revendications 2 à 5, **caractérisé en ce que** les moyens de contrôle (6) comportent un transistor MOSFET utilisé en résistance variable.

## Claims

1. Procedure for controlling the envelope of a radio signal to be transmitted from a mobile radiocommunications station, said radio signal coming from a field effect power amplifier (1) made from transistors on a substrate based on GaAs, **characterised in that** it comprises the following steps:
- sampling a control voltage (V_{dd}) applied on the power amplifier (1);
- comparing the sampled control voltage with a predefined reference voltage (V_{REF});
- making the said control voltage (V_{dd}) applied on the power amplifier (1) vary as a function of the result of the comparison.

2. A device for controlling the envelope of a radio signal to be transmitted from a mobile radiocommunications station, the said radio signal coming from a field effect power amplifier (1) made from transistors on a substrate based on GaAs, **characterised in that** it comprises:
- means (7) for sampling a control voltage (V_{dd}) applied on the power amplifier (1);
- comparison means (4) for comparing the sampled control voltage with a predefined reference voltage (V_{REF}) ;
- a control means (6) to make the said control voltage applied to the power amplifier (1) vary as a function of the result of the comparison.

3. The device according to claim 2, **characterised in that**, the said station functioning according to a digital cellular system with time division multiple access, the radio signal to be transmitted has an envelope form with a plateau preceded by a rising ramp and followed by a falling ramp, and the predefined reference voltage (V_{REF}) comes from a ramp generator (5) according to the said form of the envelope.

4. The device according to one of the claims 2 or 3, **characterised in that** the comparison means (4) comprises a differential amplifier connected, on a first input, to a predetermined voltage (V_{det}), and receiving on a second input, on the one hand, the sampled control voltage and, on the other hand, the predefined reference voltage.

5. The device according to claim 4, **characterised in that** the means (7) for sampling the control voltage allows for adaptation of the level of the sampled control voltage to be adapted as a function of the value of the predetermined voltage (V_{det}) connected to the differential amplifier (4).

6. The device according to one of the claims 2 to 5, **characterised in that** the control means (6) comprise a MOSFET transistor used in variable resistance.

## Patentansprüche

1. Verfahren zur Kontrolle der Hüllkurve eines Radiosignals, das von einer Mobilfunkstation übertragen werden soll, wobei das Funksignal aus einem Hochleistungsverstärker (1) mit Feldeffekt stammt, der aus Transistoren auf Substrat auf der Grundlage von GaAs hergestellt ist, **dadurch gekennzeichnet, dass** er die folgenden Schritte umfasst:
- Abrufen einer Steuerspannung (V_{dd}), die auf den Hochleistungsverstärker (1) angewandt ist;
- Vergleichen der abgerufenen Steuerspannung mit einer vordefinierten Bezugsspannung (V_{REF}) ;
- Variieren der Steuerspannung (V_{dd}), die auf den Hochleistungsverstärker (1) angewandt ist, je nach dem Ergebnis des Vergleichs.

2. Vorrichtung zur Kontrolle der Hüllkurve eines Radiosignals, das von einer Mobilfunkstation übertragen werden soll, wobei das Funksignal aus einem Hochleistungsverstärker (1) mit Feldeffekt stammt, der aus Transistoren auf Substrat auf der Grundlage von GaAs hergestellt ist, **dadurch gekennzeichnet, dass** er Folgendes umfasst:
- Mittel (7) zum Abrufen einer Steuerspannung (V_{dd}), die auf den Hochleistungsverstärker (1) angewandt ist;
- Mittel zum Vergleichen (4) der abgerufenen Steuerspannung mit einer vordefinierten Bezugsspannung (V_{REF});
- Mittel zur Kontrolle (6), um die Steuerspannung, die auf den Hochleistungsverstärker (1) angewandt ist, je nach dem Ergebnis des Vergleichs zu variieren.

3. Vorrichtung zur Kontrolle nach Anspruch 2, **dadurch gekennzeichnet, dass**, da die Station nach einem digitalen zellulären System mit Mehrfachzugriff mit Zeitverteilung arbeitet, das zu übertragende Radiosignal eine Hüllkurvenform aufweist, umfassend ein Plateau, dem eine ansteigende Rampe vorausgeht und dem eine abfallende Rampe folgt, und die vordefinierte Bezugsspannung (V_{REF}) aus einem Rampengenerator (5) gemäß der Hüllenkurvenform stammt.

4. Vorrichtung nach einem der Ansprüche 2 oder 3, **dadurch gekennzeichnet, dass** die Vergleichsmittel (4) einen Differenzialverstärker umfassen, der auf einem ersten Eingang mit einer vordefinierten Spannung (V_{det}) verbunden ist und auf einem zweiten Eingang einerseits die abgerufene Steuerspannung und andererseits die vorbestimmte Bezugsspannung empfängt.

5. Vorrichtung nach Anspruch 4, **dadurch gekennzeichnet, dass** die Mittel (7) zum Abrufen der Steuerspannung ermöglichen, das Niveau der abgerufenen Steuerspannung je nach dem Wert der vorbestimmten Spannung (V_{det}), die mit dem Differenzialverstärker (4) verbunden ist, anzupassen.

6. Vorrichtung zur Kontrolle nach einem der Ansprüche 2 bis 5, **dadurch gekennzeichnet, dass** die Mittel zur Kontrolle (6) einen MOSFET-Transistor umfassen, der als variabler Widerstand verwendet wird.
